# EUROPEAN PATENT APPLICATION

(11) **EP 1 801 876 A1**
(43) Date of publication of application: **27.06.2007**
(21) Application number: 05768360.9
(22) Date of filing: 02.08.2005
(51) Int. Cl.: H01L 27/146, H04N 5/335

(54) **AMPLIFIED SOLID-STATE IMAGE PICKUP DEVICE**

(30) Priority: 19.08.2004 JP 2004239819
(71) Applicant: MATSUSHITA ELECTRIC INDUSTRIAL CO., LTD., Osaka 571-8501 (JP)
(72) Inventor: INAGAKI, Makoto c/o Matsushita Electric Industrial Co., Ltd., Chuo-ku Osaka-shi Osaka 540-6319 (JP); IGAKI, Kazuaki c/o Matsushita Electric Industrial Co., Ltd., Chuo-ku Osaka-shi Osaka 540-6319 (JP); KOJIMA, Motohiro c/o Matsushita Electric Industrial Co., Ltd., Chuo-ku Osaka-shi Osaka 540-6319 (JP)
(74) Representative: Menges, Christian Alexander
(86) International application number: PCT/JP2005/014093
(87) International publication number: WO 2006/018968

(57) **Abstract**

A plurality of pixels, each including a second conductivity-type photodiode portion 1 formed in a first conductivity-type well region and an amplifier transistor 6 for amplifying and outputting charge accumulated in the photodiode portion, are arrayed two-dimensionally. Furthermore, an intra-pixel contact 2 for providing the well region with a reference voltage is provided in the photodiode portion. With this configuration, it is possible to achieve a rational intra-pixel GND contact arrangement with which the afterimage characteristics are improved and the optical characteristics are not affected adversely.

## Description

### Technical Field

The present invention relates to an amplification type solid-state imaging device having a relatively large imaging region. In particular, the present invention relates to a layout in which a pixel contact for stabilizing the image quality is arranged so as to allow the best possible use of pixel performance.

### Background Art

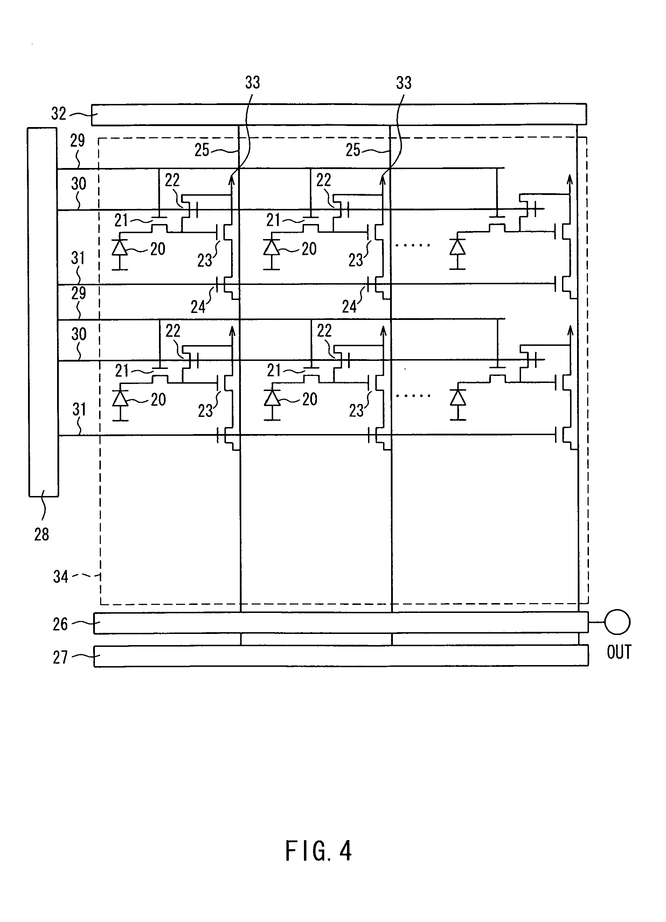

The overall configuration of a common amplification type solid-state imaging device in which four transistors are provided in each pixel will be described with reference to FIG. 4. In an imaging region 34, a plurality of pixels are arrayed two-dimensionally in m columns x n rows. Each of the pixels includes a photodiode 20, a transfer transistor 21, a reset transistor 22, a drive transistor 23, and a selection transistor 24. Signal charge obtained by photoelectric conversion by the photodiode 20 and accumulated therein is transferred by the transfer transistor 21. The signal charge is input to a gate of the drive transistor 23 after being subjected to voltage conversion. The drive transistor 23 forms a source follower together with a pixel portion power supply 33 and a load transistor group 32, and the midpoint thereof is connected to a vertical signal line 25 provided for each of the m columns arranged in the column direction. The signal input to the drive transistor 23 is transmitted via the selection transistor 24 and the vertical signal line 25 to a row signal storing portion 26 for storing signals in the row direction and outputting them. Then, a horizontal selection portion 27 selects and outputs the signals from the respective pixels. This operation is performed by sequentially scanning a transfer transistor control line 29, a reset transistor control line 30, and a row selection transistor control line 31 that are connected to a vertical selection portion 28 in the vertical direction, whereby the signals from all the pixels arrayed two-dimensionally can be output.

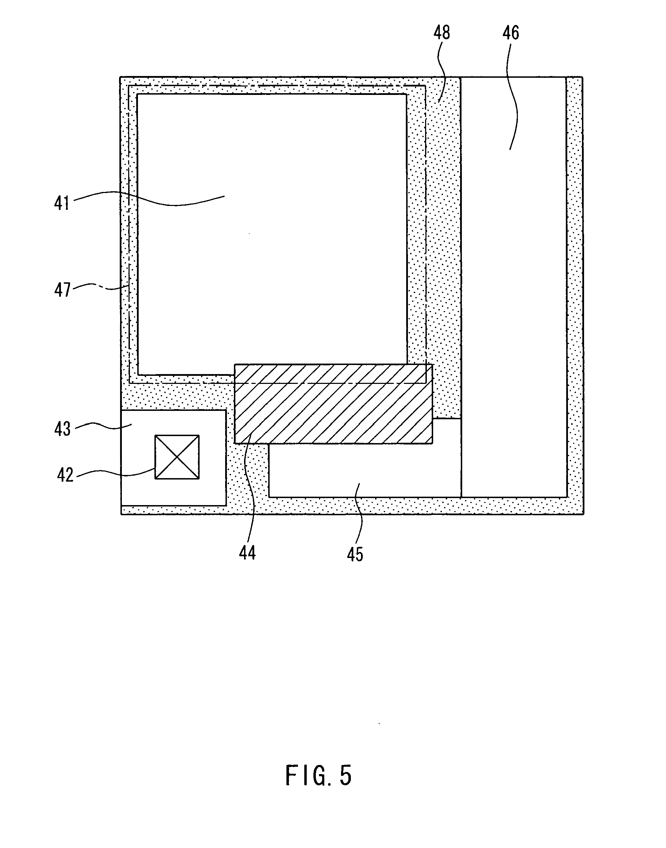

Next, one example of a conventional configuration of a pixel included in an amplification type solid-state imaging device will be described with reference to FIG. 5. FIG. 5 is a schematic plan view showing a single pixel included in an amplification type solid-state imaging device. The pixel is divided into a photodiode portion 41, a floating diffusion capacitor portion 45, and a transistor arrangement portion 46. Reference numeral 47 denotes an opening of a light-shielding aluminum layer. In the transistor arrangement portion 46, a reset transistor, a drive transistor, a selection transistor, and the like are arranged. In the photodiode portion 41, photoelectric conversion and signal charge accumulation are performed. A signal charge transfer gate 44 has the function of transferring the signal charge accumulated in the photodiode portion 41 to the floating diffusion capacitor portion 45.

An intra-pixel GND (ground) contact 42 connects a first conductivity-type well 43 to a reference potential such as a GND, thus realizing a stable potential of the well. The intra-pixel GND contact 42 is formed adjacent to the floating diffusion capacitor portion 45, and the intra-pixel GND contact 42 and the floating diffusion capacitor portion 45 are separated from each other by an inactive region 48 intervening therebetween.

With this pixel configuration, the charge transferred to the floating diffusion capacitor portion 45 as a voltage is subjected to amplification or impedance conversion by the drive transistor that is provided in the transistor arrangement portion 46. Signals from two-dimensionally arrayed pixels are read out sequentially in the X and Y directions to be output. Since a scanning circuit etc. for performing the sequential scanning in the X and Y directions do not have significant connection to the substantial configuration of the present invention, the explanation thereof will be omitted.

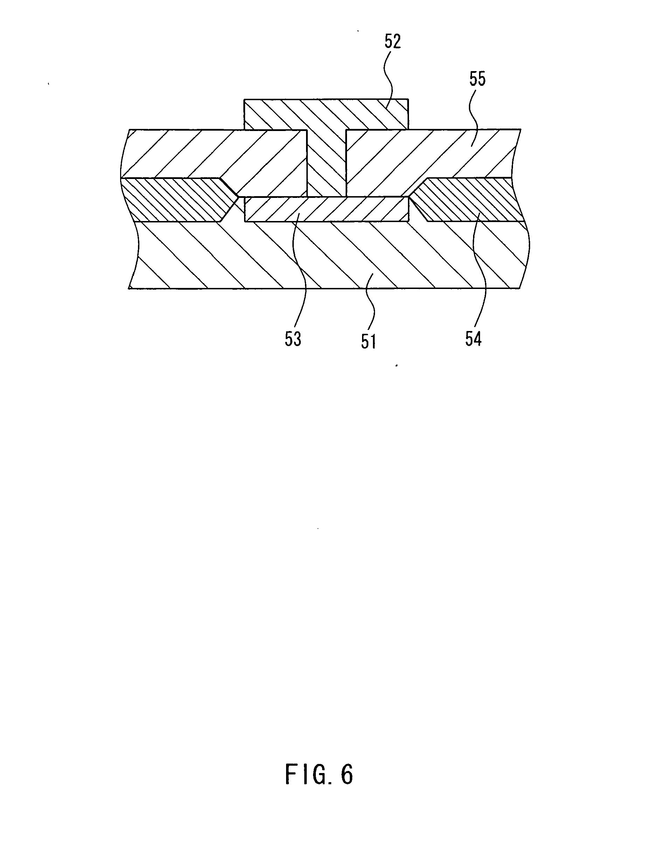

Next, the cross-sectional configuration of the conventional intra-pixel GND contact 42 will be described with reference to FIG. 6. In FIG. 6, the intra-pixel GND contact 52 is arranged above a first conductivity-type well region 51. A contact implantation portion 53 is formed in an upper part of the first conductivity-type well region 51. The contact implantation portion 53 is surrounded by an inactive region 54, and an insulating layer 55 is formed on an upper part of the contact implantation portion 53. The intra-pixel GND contact 52 is connected to the first conductivity-type well region 51 via the contact implantation portion 53 (see Patent document 1). Patent document 1: JP 2001-230400 A

### Disclosure of Invention

### Problem to be Solved by the Invention

In a solid-state imaging device that requires a large imaging region, such as, in particular, a high-performance DSC (Digital Still Camera), the first conductivity-type well region 43 is provided with the intra-pixel GND contact 42 as shown in FIG. 5 in order to stabilize the well potential. The commonly used layout is such that the intra-pixel GND contact 42 is arranged adjacent to the drain region 45. This layout is adopted based on an idea that, it is ideal that the photodiode portion 41 has a square shape or a rectangular shape with no deformation in its four sides or four corners, and in order to allow the photodiode portion 41 to have such a shape, the intra-pixel GND contact should be arranged on the drain region 45 side rather than in the photodiode portion 41.

However, this layout brings about a problem in that, since the signal charge transfer gate 44 is arranged adjacent to the drain region 45, the size of the transfer gate 44 has to be small, so that the transfer gate 44 cannot read out the signal charge completely. This problem leads to deterioration in image quality, because it affects the afterimage characteristics and deteriorates the signal linearity, for example.

Thus, it is an object of the present invention to provide an amplification type solid-state imaging device in which an intra-pixel GND contact is arranged rationally such that the afterimage characteristics are improved and the optical characteristics are not affected adversely.

### Means for Solving Problem

In order to solve the above-described problem, the present invention provides an amplification type solid-state imaging device in which a plurality of pixels are arrayed two-dimensionally, each of the pixels including a first conductivity-type well region, a second conductivity-type photodiode portion, and an amplifier transistor, wherein an intra-pixel contact for providing the well region with a reference voltage is provided in the photodiode portion.

### Effects of the Invention

According to the amplification type solid-state imaging device with the above-described configuration, since the contact for providing the well region with a reference voltage is provided in the photodiode portion, the charge transfer gate is allowed to have a large width. Therefore, the charge transfer gate can read out the signal charge sufficiently, whereby the afterimage characteristics can be improved.

### Brief Description of Drawings

[FIG. 1] FIG. 1 is a plan view schematically showing the layout of a pixel in an amplification type solid-state imaging device according to Embodiment 1.
[FIG. 2] FIG. 2 is a sectional view schematically showing the configuration of an intra-pixel GND contact in an amplification type solid-state imaging device according to Embodiment 2.
[FIG. 3A] FIG. 3A is a plan view showing the arrangement of pixels in an imaging region of an amplification type solid-state imaging device according to Embodiment 3.
[FIG. 3B] FIG. 3B is a plan view showing the layout of a pixel A in the same amplification type solid-state imaging device.
[FIG. 3C] FIG. 3C is a plan view showing the layout of a pixel B in the same amplification type solid-state imaging device.
[FIG. 4] FIG. 4 is a circuit diagram schematically showing the configuration of a conventional amplification type solid-state imaging device.
[FIG. 5] FIG. 5 is a plan view schematically showing the layout of a pixel in a conventional amplification type solid-state imaging device.
[FIG. 6] FIG. 6 is a sectional view showing the configuration of a conventional intra-pixel GND contact.

### Explanation of reference numerals

- 1: photodiode
- 2, 2a, 2b: intra-pixel GND contact
- 3, 3a, 3b: first conductivity-type well region
- 4: signal charge transfer gate
- 5: floating diffusion capacitor portion
- 6: portion where reset transistor, drive transistor, and selection transistor are arranged
- 7: opening of light-shielding aluminum layer
- 8: inactive region
- 9: imaging region
- 11: second conductivity-type photodiode implantation region
- 12: intra-pixel GND contact
- 13: first conductivity-type well region
- 14: first conductivity-type surface layer
- 15: insulating layer
- 20: photodiode
- 21: transfer transistor
- 22: reset transistor
- 23: drive transistor
- 24: selection transistor
- 25: vertical signal line
- 26: row signal storing portion
- 27: horizontal selection portion
- 28: vertical selection portion
- 29: transfer transistor control line
- 30: reset transistor control line
- 31: row selection transistor control line
- 32: load transistor group
- 33: pixel portion power supply
- 34: imaging region
- 41: photodiode
- 42: intra-pixel GND contact
- 43: first conductivity-type well region
- 44: signal charge transfer gate
- 45: floating diffusion capacitor portion
- 46: portion where reset transistor, drive transistor, and selection transistor are arranged
- 47: opening of light-shielding aluminum layer
- 48: inactive region
- 51: first conductivity-type well region
- 52: intra-pixel GND contact
- 53: first conductivity-type contact implantation portion
- 54: inactive region
- 55: insulating layer

### Description of the Invention

In the amplification type solid-state imaging device according to the present invention, it is preferable that the planar shape of the photodiode portion is rectangular and that the intra-pixel contact is arranged in the middle of either one of four sides of the rectangular area. It is also preferable that, in at least two of the pixels, positions of the intra-pixel contacts in the photodiode portions are different from each other. According to these preferable configurations, the position of the contact in the photodiode portion can be set appropriately for each pixel, so that uniform imaging characteristics with no shading can be realized without affecting the optical characteristics.

Furthermore, the amplification type solid-state imaging device may be configured so that a first conductivity-type surface layer is provided in the photodiode portion and the intra-pixel contact is connected to the well region via the surface layer. Still further, the amplification type solid-state imaging device may be configured so that a separation portion formed of an inactive region is not present between the intra-pixel contact and the photodiode portion.

Hereinafter, the amplification type solid-state imaging according to the present invention will be described by way of illustrative embodiments with reference to the drawings.

### (Embodiment 1)

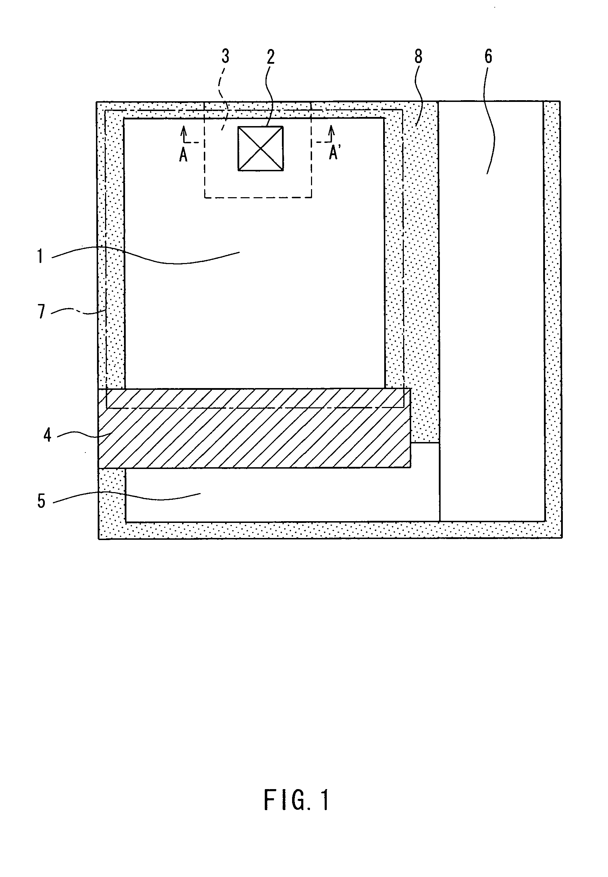

FIG. 1 is a schematic plan view showing a pixel portion of an amplification type solid-state imaging device according to Embodiment 1. The layout of this device is such that it roughly is divided into a photodiode portion 1, a floating diffusion capacitor portion 5, and a transistor arrangement portion 6. In the transistor arrangement portion 6, transistors (not shown) such as a reset transistor, a drive transistor, and a selection transistor are arranged. Between the photodiode portion 1 and the floating diffusion capacitor portion 5, a signal charge transfer gate 4 is provided. Reference numeral 7 denotes an opening of a light-shielding aluminum layer. Reference numeral 8 denotes an inactive region.

Signal charge obtained by photoelectric conversion by the photodiode portion 1 and accumulated therein is transferred to the floating diffusion capacitor portion 5 by the signal charge transfer gate 4. The signal charge is converted to a voltage in the floating diffusion capacitor portion 5 and then is subjected to amplification or impedance conversion by the drive transistor arranged in the transistor arrangement portion 6. Signals from two-dimensionally arrayed pixels, having been subjected to impedance conversion, are read out sequentially in the X and Y directions to be output. Explanation for a scanning circuit etc. for performing the sequential scanning in the X and Y directions will be omitted.

The pixel layout in the present embodiment is characterized in that an intra-pixel GND contact 2 and a first conductivity-type well region 3 are arranged in the photodiode portion 1. With this configuration, the intra-pixel GND contact 2 is not adjacent to the floating diffusion portion 5, so that the signal charge transfer gate 4 is allowed to have a large width. As a result, the signal charge transfer gate 4 can have an improved property for transferring the signal charge from the photodiode portion 1 to the floating diffusion capacitor portion 5, so that the afterimage characteristics can be improved significantly.

The pixel layout according to the present embodiment also is characterized by the following. That is, as shown in FIG. 1, the intra-pixel GND contact 2 and the first conductivity-type well region 3 are arranged in the middle of either one of four sides of the rectangular photodiode portion 1, for example. This arrangement provides the following advantage.

By arranging the intra-pixel GND contact 2 in the photodiode portion 1, the intra-pixel GND contact 2 is placed inside the opening 7 of the light-shielding aluminum layer, so that the intra-pixel GND contact 2 is exposed in a light-incident portion. In this case, if the intra-pixel GND contact 2 is arranged in an asymmetrical position in the photodiode portion 1, e.g., at the lower right of the photodiode portion 1, the output from the pixel arranged at the lower right of the imaging region becomes lower than that from the pixel arranged at the center of the imaging region.

More specifically, light incident on the imaging region exhibits the following property. That is, in the outermost diagonal pixels, the focal position tends to shift greatly toward a corner of the photodiode portion 1 as compared with that in the pixel arranged at the center of the imaging region. Therefore, when the intra-pixel GND contact is arranged at the lower right of the photodiode portion 1 in each of the pixels, the ratio of the incident light focused on the intra-pixel GND contact increases in the pixel arranged at the lower right of the imaging region.

Thus, in the pixel arranged at the lower right of the imaging region, the efficiency of photoelectric conversion decreases as compared with that in the pixel arranged at the center of the imaging region. As a result, the output becomes lower in the upper right portion of the screen (note here that the arrangement on the device appears upside down on the screen), so that, for example, when comparing the upper right portion and the lower left portion of the screen with each other, the output ratio is significantly lower in the upper right portion, resulting in the deteriorated output symmetry

The cause of the output asymmetry in the imaging region is closely related to the position where the intra-pixel GND contact 2 is provided in the photodiode portion 1 as described above. Although the above example is directed to the case where the intra-pixel GND contact is arranged at the lower right of the photodiode portion 1, the property of light incident on the imaging region is affected similarly when the intra-pixel GND contact is arranged at a corner of the rectangular photodiode portion 1, such as an upper right portion or an upper left portion of the photodiode portion 1.

In contrast, when the intra-pixel GND contact is arranged in the middle of either one of four sides of the rectangular photodiode portion 1 as in the present embodiment, it is possible to decrease the ratio of light focused on the intra-pixel GND contact 2 in the outermost diagonal pixels that are optically farthest from the center of the imaging region and in which the center of focus is liable to shift toward a corner of the photodiode portion. Thus, it is possible to suppress the occurrence of the output asymmetry in the diagonal direction of the screen.

On the other hand, arranging the intra-pixel GND contact 2 in the middle of either one of four sides of the rectangular photodiode portion 1 brings about a concern that a portion exhibiting a lower output is formed in the upper or lower center of the screen or the left or right center of the screen due to the influence of the intra-pixel GND contact 2. However, the variation in focal position between the central portion and the peripheral portion of the screen is less significant than that between the diagonal portions of the imaging region. Thus, it is possible to address the above-described concern by optimizing the size of the intra-pixel GND contact 2.

### (Embodiment 2)

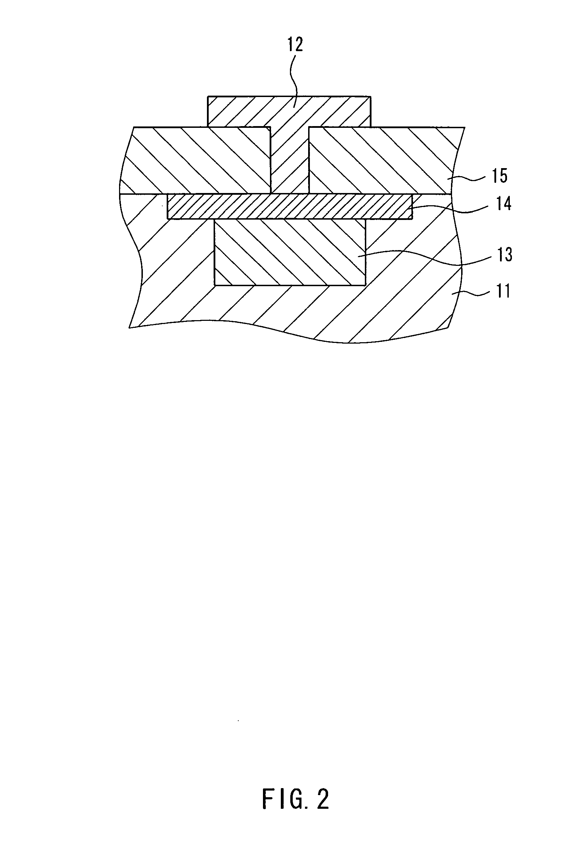

An amplification type solid-state imaging device according to Embodiment 2 will be described with reference to FIG. 2, which shows a cross-sectional configuration of an intra-pixel GND contact.

A first conductivity-type well region 13 and a first conductivity-type surface layer 14 are formed in a second conductivity-type photodiode implantation region 11. An intra-pixel GND contact 12 is provided and is connected to the first conductivity-type surface layer 14 through an insulating layer 15.

The present embodiment is characterized in that the first conductivity-type surface layer 14, which also can serve as a contact implantation portion, is used for the connection between the intra-pixel GND contact 12 and the first conductivity-type well region 13. The impurity concentration of the first conductivity-type surface layer 14 is set to 1.0 × 10¹³ to 1.0 × 10¹⁵. Since the impurity concentration of the first conductivity-type implantation region used as a contact implantation portion generally is set to 1.0 × 10¹³ to 1.0 × 10¹⁴, it is quite feasible to use the first conductivity-type surface layer 14 also as the contact implantation portion. This eliminates the necessity of performing contact implantation. Thus, the damage caused by implantation can be reduced so as to reduce the pixel defects, and also the process steps required for obtaining the pixel can be reduced.

### (Embodiment 3)

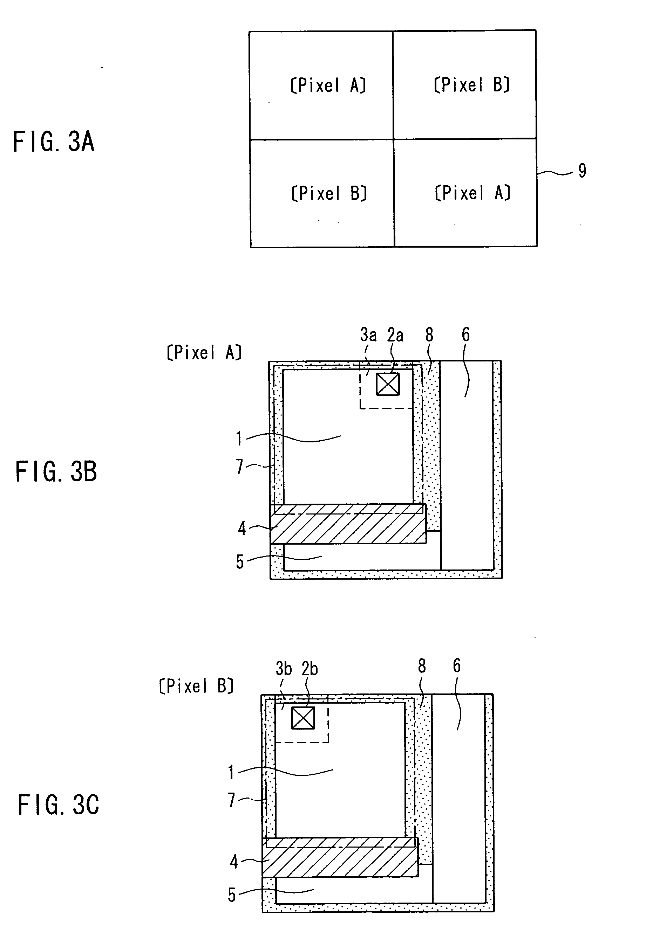

An amplification type solid-state imaging device according to Embodiment 3 will be described with reference to FIGs. 3A to 3C, which show the layout of pixels. FIG. 3A is a plan view schematically showing an imaging region 9 (only four pixels are shown). FIGs. 3B and 3C are plan views each showing a pixel layout.

The present embodiment is characterized in that at least two types of pixels that differ from each other in the position of the intra-pixel GND contact are arranged in an imaging region 9. More specifically, in a pixel A, an intra-pixel GND contact 2a and a first conductivity-type well region 3a are arranged on the right of the upper side of a photodiode 1, whereas, in a pixel B, an intra-pixel GND contact 2b and a first conductivity-type well region 3b are arranged on the left of the upper side of a photodiode 1. As shown in FIG. 3A, the pixels A are arranged at the upper left and the lower right of the imaging region 9, and the pixels B are arranged at the lower left and the upper right of the imaging region 9.

Light incident on each pixel in the imaging region 9 is focused on the photodiode portion 1 by a lens disposed on the pixel, for example. However, as the pixel is located farther from the center of the imaging region 9, light is incident thereon more obliquely. Thus, the focal position on the photodiode portion 1 deflects depending on the position of the pixel in the imaging region 9. For example, in the region of the pixel A, the focal position on the photodiode portion 1 deflects approximately in the direction extending from the upper left to the lower right, while in the region of the pixel B, the focal position on the photodiode portion 1 deflects approximately in the direction extending from the lower left to the upper right. Thus, the intra-pixel GND contacts 2a and 2b preferably are arranged so as to avoid the positions along the direction where the above-described deflection of the focal position occurs. This can prevent the variation in sensitivity between the pixels.

Although the above-described example is directed to the case where there are two types of intra-pixel GND contact positions, the positions of the intra-pixel GND contacts in all the pixels may be different from one another. For example, it is possible to change the positions of the intra-pixel GND contacts gradually from the pixel arranged at the center of the imaging region 9. Also, the way of dividing the pixels into groups with different intra-pixel GND contact positions is not particularly limited as long as the same effect is obtained.

### (Embodiment 4)

An amplification type solid-state imaging device according to Embodiment 4 will be described. The pixel layout according to the present embodiment is characterized in that, unlike the conventional example shown in FIG. 5, a pixel portion GND contact 2 and a first conductivity-type well region 3 are not separated from a photodiode portion 1 adjacent thereto by an inactive region, as shown in FIG. 1. That is, the pixel portion GND contact 2 and the photodiode portion 1 are formed in the same active region and are not separated from each other by an inactive region.

This configuration is not feasible unless the intra-pixel GND contact 2 is provided in the photodiode portion 1. The reason for this will be described with reference to the conventional pixel layout shown in FIG. 5. When the intra-pixel GND contact 42 is formed adjacent to the floating diffusion capacitor portion 45 as in the conventional example, since the potential of the floating diffusion capacitor portion 45 is set to a maximum power supply voltage, e.g., 5 V, the potential difference between the floating diffusion capacitor portion 45 and the intra-pixel GND contact 42 is 5 V In particular, because the contact implantation portion 53 (see FIG. 6) used for the connection between the intra-pixel GND contact 42 and the first conductivity-type well region 43 is in contact with the floating diffusion capacitor portion 45 in the state where both the contact implantation portion 53 and the floating diffusion capacitor portion 45 have high impurity concentrations, damages are liable to be caused by the electric field. Therefore, it is essential to provide the inactive region 48.

In contrast, in the present embodiment, the maximum potential of the photodiode portion 1 is about 2 V at most, and thus the potential difference between the photodiode portion 1 and the intra-pixel GND contact 2 is small. In addition, the impurity concentration of the photodiode portion 1 is lower than that of the floating diffusion capacitor portion 5. Therefore, even if the photodiode portion 1 is not separated from the intra-pixel GND contact 2 by the inactive region 8, there is no chance that the photodiode portion 1 might be damaged. With this configuration, it is possible to obtain an effect that there are no defects caused by the formation of the inactive region and also the occurrence of dark outputs or white flaws can be suppressed.

Note here that, in the above-described embodiments, the intra-pixel GND contact 2 is not limited only to a ground, and any components that can fix a reference potential to a certain value can stabilize the potential of the well region 3.

Also note that, in the above-described embodiments, it is not always necessary that the entire intra-pixel GND contact 2 is within the rectangular area defined by the photodiode portion 1, and a part of the intra-pixel GND contact 2 may stick out from the rectangular area.

### Industrial Applicability

In the amplification type solid-state imaging device according to the present invention, an intra-pixel GND contact is arranged rationally such that the afterimage characteristics of the device are improved and the optical characteristics are not affected adversely. Hence, the amplification type solid-state imaging device according to the present invention is useful as a lens-changeable high-quality digital still camera with a large imaging size, a dental X-ray input solid-state imaging device, and a face profile image input device.

## Claims

1. An amplification type solid-state imaging device in which a plurality of pixels are arrayed two-dimensionally, each of the pixels including: a second conductivity-type photodiode portion formed in a first conductivity-type well region; and an amplifier transistor for amplifying and outputting charge accumulated in the photodiode portion,
wherein an intra-pixel contact for providing the well region with a reference voltage is provided in the photodiode portion.

2. The amplification type solid-state imaging device according to claim 1, wherein a planar shape of the photodiode portion is rectangular, and the intra-pixel contact is arranged in the middle of either one of four sides of the rectangular.

3. The amplification type solid-state imaging device according to claim 1, wherein, in at least two of the pixels, positions of the intra-pixel contacts in the photodiode portions are different from each other.

4. The amplification type solid-state imaging device according to any one of claims 1 to 3, wherein a first conductivity-type surface layer is provided in the photodiode portion, and the intra-pixel contact is connected to the well region via the surface layer.

5. The amplification type solid-state imaging device according to any one of claims 1 to 4, wherein a separation portion formed of an inactive region is not present between the intra-pixel contact and the photodiode portion.
